# EUROPEAN PATENT APPLICATION

(11) **EP 1 848 050 A2**
(43) Date of publication of application: **24.10.2007**
(21) Application number: 07106121.2
(22) Date of filing: 13.04.2007
(51) Int. Cl.: H01L 51/52

(54) **Organic electroluminescent element having a microstructure between a transparent substrate and an electrode**

(30) Priority: 17.04.2006 JP 2006113761
(71) Applicant: International Test & Engineering Services Co., Ltd, Kuratsu-shi, Shiga 525-0025 (JP)
(72) Inventor: Kozaki, Kenji, Kusatsu-shi Shiga 525-0027 (JP); Morimoto, Tsutomu, Konan-shi Shiga 520-3233 (JP); Ayukawa, Shigeru, Nagoya-shi 463-0031 (JP); Tsutsui, Naganori, Yasu-shi Shiga 520-2331 (JP); Miura, Nobuhito, Otsu-shi Shiga 520-0865 (JP); Katoh, Masahiro, Konan-shi Shiga 520-3108 (JP)
(74) Representative: Skuhra, Udo

(57) **Abstract**

Problem To be Solved: To provide an organic EL element as well as a method for manufacturing the same, wherein a structure having a microscopic unevenness and a specific refractive index is incorporated in the organic EL element, and which has such a high luminous efficiency that it can be used as an illumination light source in which the transmittance of light at the interface between an electrode and a transparent substrate within the organic EL element is improved.

Means for Solving the Problem: An organic EL element with high luminous efficiency is manufactured by fabricating a compound substrate by forming a microscopic unevenness on a transparent substrate of glass or the like using a sol-gel material and a nanoimprinting method, applying a high refractive index material on the microscopic unevenness, and planarizing the surface, and layering a first electrode, an organic solid layer including an organic light-emitting material and a first electrode in that order on the compound substrate.

## Description

### TECHNICAL FIELD

The present invention relates to an organic electroluminescent (EL) element that has a high luminous efficiency and can be used as a light source of an illuminating device, as well as a method for manufacturing the same.

### BACKGROUND ART

Organic EL elements, which have inherent light emission capability and furthermore low power consumption, are not only used for pixels constituting display devices, but also have an excellent potential of being used as light-emitting elements in various types of illumination fixtures. If organic EL elements could be used as light-emitting elements in illumination fixtures, they would have better impact resistance and would be easier to handle than current incandescent light bulbs or fluorescent lamps, since organic EL elements are solid state elements, so that it would also become possible to realize illumination fixtures having special shapes that cannot be realized with current incandescent light bulbs or fluorescent lamps, leading to a wide range of applications.

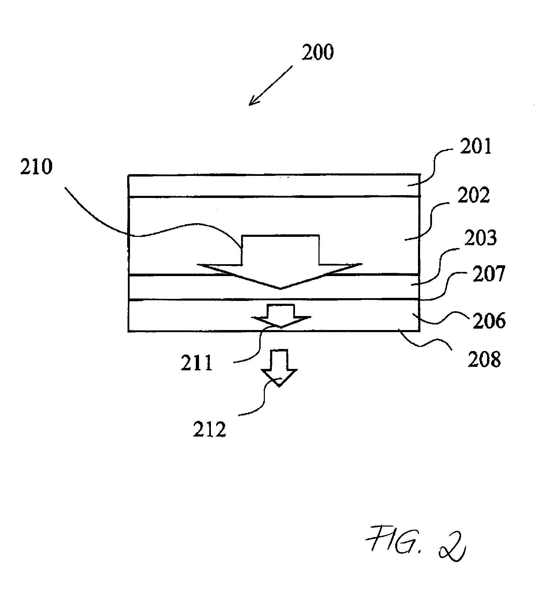

However, with the structure of conventional organic EL elements, the light that is emitted from an organic light-emitting layer passes through the transparent substrate and other layers around it, and is attenuated to a level of 20% of the emitted light before reaching the outside. This is explained with reference to Fig. 2. Fig. 2 is a diagrammatic cross-sectional view illustrating how light emitted from the light-emitting layer of an organic EL element reaches the outside. When light 210 that is radiated from the light-emitting layer of the organic EL element passes through the transparent substrate and reaches the outside, it is attenuated as indicated by the light 211. It is known that the main reason for this attenuation is reflections at the interface between the electrode and the transparent substrate within the organic EL element as well as at the interface between the transparent substrate and air. As a countermeasure for this problem, it is known that it is advantageous to arrange a microscopic uneven structure not greater than the wavelength of visible light at the interface between substances of different refractive index.

Conventionally, such a microscopic uneven structure was fabricated using an etching process.

A microscopic uneven structure is disclosed for example in Yong-Jae Lee et al, Appl. Phys. Lett. 82 (2003) 3779 and M. Fujita et al, Electron. Lett. 39 (2003)1750.

However, when an etching process is used, the processing becomes complicated, and it becomes difficult to manufacture such a microscopic uneven structure at a low price.

Accordingly, it is an object of the present invention to provide an organic EL element as well as a method for manufacturing the same, with which the microstructure can be manufactured at low cost using a nanoimprinting method not including an etching process, which can be used not only for applications as a pixel of a display device, but also as a light-emitting element of an illumination fixture.

In order to achieve this object, an organic electroluminescent element in accordance with a first aspect comprises:
a transparent substrate,
a sol-gel layer formed on the transparent substrate, the layer being made of a sol-gel material and having a microscopic unevenness (or roughness) in its surface,
a high refractive index material layer formed on the sol-gel layer by applying a high refractive index material to fill gaps in the unevenness of the sol-gel layer,
a first electrode formed on a multi-layer substrate (also referred to as "compound substrate" in the following) made of the transparent substrate, the sol-gel layer and the high refractive index material layer,
an organic solid light-emitting layer (also referred to as "light-emitting layer" in the following) including an organic light-emitting material formed on the first electrode, and
a second electrode formed on the light-emitting layer,
wherein the microscopic unevenness of the sol-gel layer is formed by nanoimprinting.

In accordance with a second aspect, in the organic electroluminescent element according to the first aspect,
the first electrode is a transparent electrode made of one selected from ITO, IZO and ZnO, or one selected from Au, Ag and Al, or an alloy including at least one metal selected from the group of Au, Ag and Al.

In accordance with a third aspect, in the organic electroluminescent element according to the first or second aspect,
the transparent substrate is a glass substrate.

In accordance with a fourth aspect, in the organic electroluminescent element according to any of claims the first to third aspect,
the refractive index of the sol-gel material is 1.30 to 1.60, and the refractive index of the high refractive index material used for planarizing the unevenness by applying it to the gaps in the unevenness of the sol-gel layer is 1.60 to 2.20.

In accordance with a fifth aspect, in the organic electroluminescent element according to any of the first to fourth aspects,
the microscopic unevenness of the sol-gel layer is formed by applying a sol-gel material to the transparent substrate, pressing and heating a die having a microscopic unevenness against the application surface, and separating the die, after the sol-gel material has been applied to the transparent substrate, and wherein the unevenness is planarized by applying a high refractive index material to the unevenness.

In accordance with a sixth aspect, in the organic electroluminescent element according to any of the first to fifth aspects,
the high refractive index material is an oxide of at least one metal selected from the group consisting of zirconium, aluminum, germanium and titanium.

In accordance with a seventh aspect, in the organic electroluminescent element according to any of the first to sixth aspects,
a difference H between valleys and peaks of the microscopic unevenness of the sol-gel layer is 10 nm to 10 µm, and a pitch W between valleys and peaks of the unevenness is 10 nm to 10 µm.

In accordance with an eighth aspect, in the organic electroluminescent element according to any of the first to seventh aspects,
a difference between the refractive index of the transparent substrate and the refractive index of the sol-gel layer is within a range of ±0.2, which is achieved by solidifying the sol-gel material after forming the microscopic unevenness in the sol-gel layer by pressing and heating a die having a microscopic unevenness against the sol-gel material, and separating the die.

In accordance with a ninth aspect, in the organic electroluminescent element according to any of the first to eighth aspects,
a difference between the valleys and peaks of the surface planarized by applying the high refractive index material is not greater than 20% of a difference H between valleys and peaks of the unevenness of the sol-gel layer.

In accordance with a tenth aspect, a method for manufacturing an organic electroluminescent element having a microscopic uneven structure made of a sol-gel material and a high refractive index material on a transparent substrate comprises:
a step of applying a sol-gel material on a transparent substrate;
a step of forming a sol-gel layer having a microscopic unevenness by pressing and heating a die having a microscopic unevenness against the applied sol-gel material, and separating the die,
a step of planarizing the unevenness by applying a high refractive index material on the microscopic unevenness, to form a high refractive index material layer,
and a step of layering a first electrode, an organic solid layer including an organic light-emitting material and a second electrode in that order on the planarized surface.

In accordance with an eleventh aspect, in the method for manufacturing an organic EL element according to the tenth aspect,
the first electrode is a transparent electrode made of one selected from ITO, IZO and ZnO, or one selected from Au, Ag and Al, or an alloy including at least one metal selected from the group of Au, Ag and Al.

In accordance with a twelfth aspect, in the method for manufacturing an organic EL element according to the tenth or eleventh aspect,
the transparent substrate is a glass substrate.

In accordance with a thirteenth aspect, in the method for manufacturing an organic EL element according to any of claims the tenth to twelfth aspects,
the refractive index of the sol-gel material is 1.30 to 1.60, and the refractive index of the high refractive index material is 1.60 to 2.20.

In accordance with a fourteenth aspect, in the method for manufacturing an organic EL element according to any of the tenth to thirteenth aspects,
the high refractive index material is an oxide of at least one metal selected from the group consisting of zirconium, aluminum, germanium and titanium.

In accordance with a fifteenth aspect, in the method for manufacturing an organic EL element according to any of the tenth to fourteenth aspects,
a difference H between valleys and peaks of the microscopic unevenness of the sol-gel layer is 10 nm to 10 µm, and a pitch W between valleys and peaks of the unevenness is 10 nm to 10 µm.

In accordance with a sixteenth aspect, in the method for manufacturing an organic EL element according to any of the tenth to fifteenth aspects,
a difference between the refractive index of the transparent substrate and the refractive index of the sol-gel layer is within a range of ±0.2, which is achieved by solidifying the sol-gel material after forming the microscopic unevenness in the sol-gel layer by pressing and heating a die having a microscopic unevenness against the sol-gel material, and separating the die.

In accordance with a seventeenth aspect, in the method for manufacturing an organic EL element according to any of the tenth to sixteenth aspects,
a difference between the valleys and peaks of the surface planarized by applying the high refractive index material is not greater than 20% of a difference H between valleys and peaks of the unevenness of the sol-gel layer.

With the subject matter of the first aspect, it is possible to improve the luminous efficiency of the organic EL element. This is explained with reference to the drawings.

Fig. 2 is a cross-sectional view of an organic EL element with a conventional structure, showing how light radiated from the light-emitting layer is emitted from the organic EL element. In Fig. 2, numeral 210 denotes the light that is radiated from a light-emitting layer 202 and is incident on a first electrode 203. Here, the width of the arrows indicates the amount of light. The light 211 represents that part of the light 210 incident on the first electrode 203, that passes through a first interface 207, which is the interface between the first electrode 203 and a transparent substrate 206, and enters the transparent substrate 206. As shown in Fig. 2, when the light 210 emitted from the light-emitting layer 202 passes through this interface, it is attenuated considerably. The main reason for this is that due to the difference in the refractive indices of the first electrode 203 and the transparent substrate 206, a considerable amount of the light incident on the first interface 207 is reflected and cannot be passed through the first interface 207. Also the light 211 that has passed through the first interface 207 is attenuated for the same reason at the second interface 208 between the transparent substrate 206 and the outside. As a result, the amount of light 212 that is passed through the second interface 208 is smaller than the amount of light 211.

On the other hand, in the case of the organic EL element according to the first aspect, there is little attenuation of the amount of light at the interface, the amount of light that is ultimately emitted to the outside of the organic EL element is increased, and the luminous efficiency is improved.

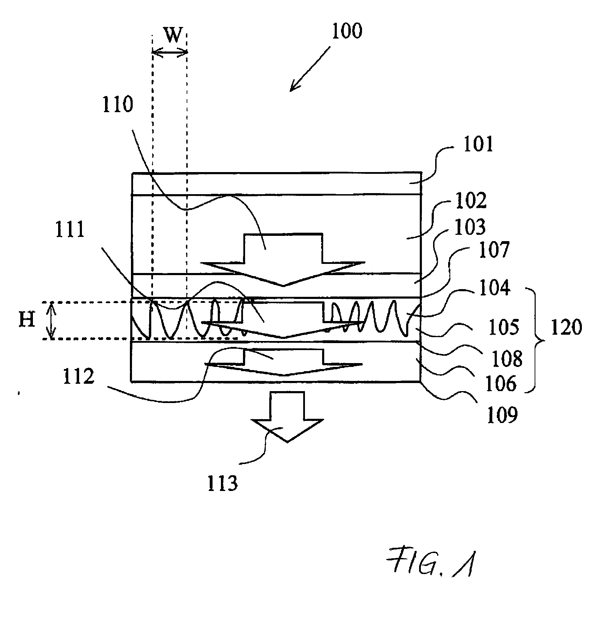

Fig. 1 is a cross-sectional view of an organic EL element 100 in accordance with the first aspect. When the light 110 that is emitted from a light-emitting layer 102 passes from an organic EL light-emitting layer 102 through a first interface 107 between a first electrode 103 and a high refractive index material layer 104, it is attenuated and becomes the light 111, but the degree of attenuation is lower than that at the first interface 207 in Fig. 2. The reason why it is lower lies in the value of the refractive index of the high refractive index material layer 104 and the shape of the microscopic unevenness.

Then, when the light 111 passes through a second interface 108, which is the interface between a sol-gel layer 105 and the transparent substrate 106, it is attenuated and becomes the light 112, and the amount of light is reduced, but the degree of attenuation is lower than in the case of the conventional organic EL element. The reason why the degree of attenuation is lower is that the refractive index of the sol-gel layer 105 approximates the refractive index of the transparent substrate, and also lies in the effect of the uneven shape (or roughness) of the sol-gel layer. The light 112 that has passed through the second interface 108 passes through a third interface 109, which is the interface between the transparent substrate 106 and the outside, and becomes the light 113, which is emitted to the outside.

As explained above, with the subject matter of the first aspect, it is possible to suppress the attenuation of the light amount at the interfaces and to improve the overall luminous efficiency of the organic EL element by providing the sol-gel layer 105 and the high refractive index material layer 104.

It should be noted that, more specifically, the light 110 is that part of the light emitted in the light-emitting layer that has passed through the interface between the light-emitting layer 102 and the first electrode, but the attenuation at this interface is the same proportion in a conventional organic EL element as in the case of an organic EL element according to the present invention, so that for the sake of simplicity, this attenuation is ignored in the explanations of this specification.

In accordance with the second aspect, the same effect as with the first aspect can be attained also for an organic EL element in which the transparent electrode is made of one selected from ITO, IZO and ZnO, or one selected from Au, Ag and Al, or an alloy including at least one metal selected from the group of Au, Ag and Al.

In accordance with the third aspect, the same effect as with the first aspect can be attained also for an organic EL element in which the transparent substrate is made of glass.

In accordance with the fourth aspect, by setting the refractive index of the sol-gel material 1.30 to 1.60, and the refractive index of the high refractive index material used for filling the microscopic unevenness to 1.60 to 2.20, the difference between the refractive indices at the interface between the sol-gel layer made of sol-gel material and the transparent substrate can be made small, and also the difference between the refractive indices at the interface between the high refractive index material layer made of high refractive index material and the electrode can be made comparatively small. As a result, the optical transmittance at these interfaces can be improved.

In accordance with the fifth aspect, the same effect as with the first aspect can be attained also for an organic EL element in which the microscopic unevenness of the sol-gel layer is formed by applying a sol-gel material to the transparent substrate, pressing and heating a die having convex and concave portions corresponding to the concave and convex microscopic unevenness against the application surface, and separating the die, and in which a compound substrate is fabricated by planarizing the unevenness by applying/filling a high refractive index material to the unevenness (also referred to as "the nanoimprinting method" in the following). An organic EL element having a structure as shown in Fig. 1 can be manufactured using for example an etching step instead of the nanoimprinting method. However, in order to use the organic EL element as an illumination light source, an organic EL element with a large light emission area is necessary, and when an organic EL element with a large light emission area is manufactured using an etching step, the manufacturing costs may become too high. On the other hand, with the nanoimprinting method, the manufacturing equipment necessary for an etching step is not necessary, and it is possible make the manufacturing process simpler than with an etching process, so that the manufacturing costs can be reduced and mass production becomes feasible.

Also in accordance with the sixth aspect, it is possible to attain the same effect as with the first aspect.

Also in accordance with the seventh aspect, it is possible to attain the same effect as with the first aspect.

Also in accordance with the eighth aspect, it is possible to attain the same effect as with the first aspect.

Also in accordance with the ninth aspect, it is possible to attain the same effect as with the first aspect.

In accordance with the tenth aspect, it is possible to attain the same effect as with the first aspect.

In accordance with the eleventh aspect, it is possible to attain the same effect as with the second aspect.

In accordance with the twelfth aspect, it is possible to attain the same effect as with the third aspect.

In accordance with the thirteenth aspect, it is possible to attain the same effect as with the fourth aspect.

In accordance with the fourteenth aspect, it is possible to attain the same effect as with the sixth aspect.

In accordance with the fifteenth aspect, it is possible to attain the same effect as with the seventh aspect.

In accordance with the sixteenth aspect, it is possible to attain the same effect as with the eighth aspect.

Also in accordance with the seventeenth aspect, it is possible to attain the same effect as with the ninth aspect.

### BRIEF EXPLANATION OF THE DRAWINGS

Fig. 1 is a cross-sectional drawing showing the structure of an organic EL element according to the present invention.
Fig. 2 is a cross-sectional drawing showing the structure of a conventional organic EL element according to the present invention.
Fig. 3 is a cross-sectional view illustrating a manufacturing process for a microscopic unevenness according to the present invention.
Fig. 4 is a cross-sectional view illustrating a manufacturing process for a conventional microstructure.
Fig. 5 is a cross-sectional process diagrams illustrating a process for manufacturing an organic EL element according to the present invention.

### PREFERRED EMBODIMENTS OF THE INVENTION

Referring to the accompanying drawings, the following is an explanation of preferred embodiments of the present invention.

Fig. 1 is a cross-sectional view showing the structure of an organic EL element according to an aspect of the present invention. A compound substrate 120 is made of a transparent substrate 106, a sol-gel layer 105, and a high refractive index material layer 104. An example of the transparent substrate 106 is a glass substrate.

The sol-gel layer 106 is fabricated by so-called nanoimprinting using a sol-gel material, and is a microstructure in which the difference H between the valleys and the peaks of a microscopic unevenness is for example 10 nm to 10 µm. Also the pitch W between the valleys and peaks of the unevenness is microscopic at 10 nm to 10 µm. The high refractive index material layer 104 is fabricated by coating a high refractive index material onto the sol-gel layer 105. A first electrode 103 functions as an anode or a cathode of the organic EL element. A light-emitting layer 102 serves as the light-emitting layer of the organic EL element and more specifically includes an electron transport layer, a light-emitting layer and a hole transport layer. A second electrode 101 functions as an anode or a cathode of the organic EL element. The portions that are arranged on top of the high refractive index material layer 104 may have the same structure as organic EL elements known in the art, and their manufacturing method may be the same as manufacturing methods known in the art. Accordingly, further explanations of their structure and manufacturing method are omitted.

The following is an explanation of a method for fabricating the sol-gel layer 105 and the high refractive index material layer 104.

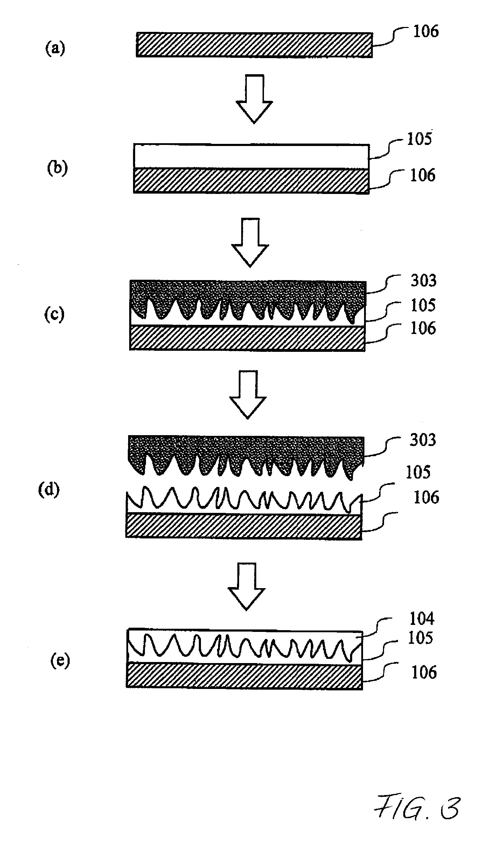

Fig. 3 shows cross-sectional views illustrating an outline of a process for fabricating the sol-gel layer 105 and the high refractive index material layer 104. This fabrication method is also referred to as a "nanoimprinting method".

First, the transparent substrate 106 is cleaned by ultrasonic cleaning or the like. Then, a sol-gel material is applied to the transparent substrate 106 (see Fig. 3(b)). It should be noted that the transparent substrate may be for example a glass substrate. However, as long as it is a transparent substrate, it does not necessarily have to be a glass substrate. An alkoxysilane is used as the sol-gel material. However, the sol-gel material is not limited to alkoxysilane, and it may also be a sol-gel material whose refractive index can be adjusted by adding a metal alkoxide or a metal oxide. Here, the metal oxide may be an oxide of titanium, germanium, aluminum, zirconium or zinc. Moreover, the application method may be spin-coating, spray-coating or slit-coating, but the application method is not limited to these. The applied film thickness is set to for example 100 nm to 10 µm. Next, the entire substrate, on which the sol-gel material has been applied, is pre-baked. The sol-gel material is semi-hardened by baking with a hot-plate or an infrared heater. The temperature to which it is heated is for example 18°C to 150°C, and the heating time is 5 min to 60 min.

Next, a die 303 having a microscopic unevenness is pressed against the sol-gel material 105 (the numeral 105 is used for the sol-gel layer having a microscopic unevenness, but since also the state of the material not having this unevenness is physically the same, the same reference numeral 105 is used for it as well) and heated (see Fig. 3(c)).

The die 303 includes a microscopic unevenness, which is formed for example with a pitch of 10 nm to 10 µm. The shape of this unevenness may be uniform, or it may be an irregular uneven shape instead of a constantly regular shape, as shown in Fig. 3(c). The presence of the unevenness (or roughness) reduces the reflections at the interface between substances made of materials with different refractive indices, so that it allows a larger amount of light to pass through the interface. However, this effect depends on the wavelength of the light and the dimensions of the unevenness, in other words, a particular dimension is suitable for a particular wavelength. Accordingly, when light of several wavelengths is to be irradiated onto the microscopic unevenness, a suitable microscopic unevenness is achieved by providing the microscopic unevenness with various shapes and/or various sizes, thereby making it possible to increase the optical transmittance.

Moreover, as the conditions when pressing the die 303 against the sol-gel material 105 and heating it, a pressure of 10 to 2000 N/cm² and a pressing time of 5 to 60 min is possible. As for the heating conditions, the heating temperature can be 18 to 500°C, and the press-heating time can be 5 to 60 min.

Next, after the sol-gel material 105 has solidified, the die 303 is separated from the sol-gel material 105 (Fig. 3 (d)). With this process, a sol-gel layer 105 having a microscopic structure with a pitch of 10 nm to 10 µm and a difference of 10 nm to 10 µm between the valleys and the peaks of the unevenness is formed on the transparent substrate 106.

Next, a high refractive index material 104 (the numeral 104 is used for the high refractive index material, but since also the state of the material prior to shaping to the high refractive index material is physically the same, the same reference numeral 104 is used for it as well) is applied on the sol-gel layer 105, and its surface is planarized (see Fig. 3 (e)). For the high refractive index material, aluminum oxide can be used, for example.

It should be noted that the planarization is also important with regard to improving the reliability of the organic EL element according to the present invention.

The following is an explanation of a process for manufacturing an organic EL element according to the present invention by layering the first electrode 103, the light-emitting layer 102 and the second electrode 101 in that order on the compound substrate 120.

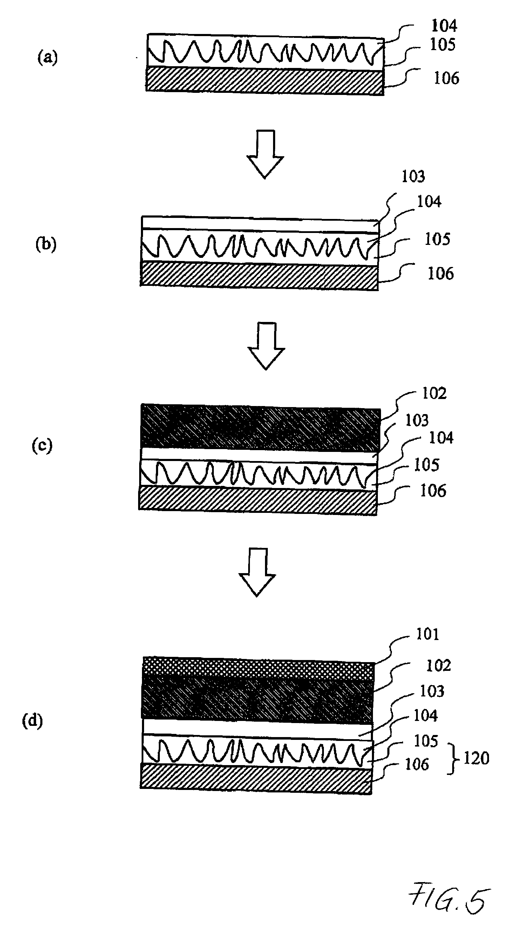

Fig. 5 shows cross-sectional views illustrating an outline of a process for manufacturing an organic EL element according to the present invention by layering a first electrode 103, a light-emitting layer 102 and a second electrode 101 in this order on the compound substrate 120.

The method of layering, in order, the first electrode, the light-emitting layer 102, and the second electrode 101 on the compound substrate 120 fabricated by the process illustrated in Fig. 3 can be a process for fabricating an organic EL element as known in the art, and does not include any characteristic features.

Firstly, the first electrode 103 is formed with, for example, ITO or IZO on the compound substrate 120, through film formation by sputtering (Fig. 5 (b)). Then, the light-emitting layer 102 is formed on the first electrode through film formation of an organic EL material (see Fig. 5 (c)). Then, the second electrode is formed by vacuum vapor deposition or sputtering through film formation of one of the metals chosen from Al (aluminum), Ag (silver), Au (gold), Cu (copper), Mo (molybdenum), Cr (chromium), Ni (nickel), Pt (platinum), Ti (titanium) and Ta (tantalum).

The following is an explanation of the effect of the invention according to the present embodiment.

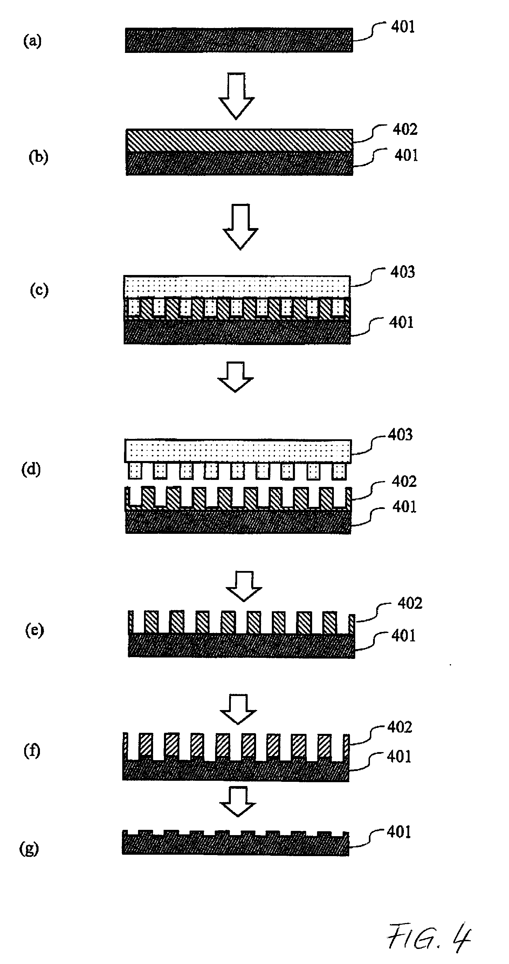

The effects of the invention according to the present embodiment lie in the aspect that the luminous efficiency of the organic EL element having a sol-gel layer and a high refractive index material layer as shown in Fig. 1 is increased and the aspect that an organic EL element having a microscopic unevenness can be manufactured by nanoimprinting, or more specifically, by a process as shown in Fig. 3. In order to clarify these aspects, a conventional manufacturing method is explained. Fig. 4 shows cross-sectional process diagrams of a conventional manufacturing method. First, a resist 402 is applied to a transparent substrate 401 (see Fig. 4 (b)). Then, a die 403 having a microscopic unevenness is pressed against the resist 402, and the thickness of a predetermined portion of the resist 402 is selectively reduced (see Fig. 4 (c)). Then, the die 403 is separated from the resist 402. As a result, the resist 402 remains with its thickness being selectively reduced in a predetermined region (see Fig. 4 (d)). In the following, this remaining portion is referred to as "residue".

Then, substrate including the residue is etched with a hydrofluoric acid based chemical (see Fig. 5 (e)). As a result, the transparent substrate 401 below the portions where the resist 402 is thin is selectively etched away, and a substrate 401 having an unevenness at its surface as shown in Fig. 4 (g) can be manufactured.

Compared to this conventional manufacturing method, the process shown in Fig. 3 does not include an etching step, so that the process is simple, the manufacturing costs can be reduced, and the process is suitable for mass production.

### EXPLANATION OF THE REFERENCE NUMERALS

- 100: organic EL element according to the present invention
- 101: second electrode
- 102: organic EL light-emitting layer
- 103: first electrode
- 104: high refractive index material layer
- 105: sol-gel layer
- 106: transparent substrate
- 107: first interface
- 108: second interface
- 109: third interface
- 110: light incident on first interface from organic EL light-emitting layer of organic EL element according to the present invention
- 111: light incident on second interface of organic EL element according to the present invention
- 112: light incident on third interface of organic EL element according to the present invention
- 113: light emitted to the outside from organic EL element according to the present invention
- 120: compound substrate
- H: difference between valleys and peaks
- W: pitch between valleys and peaks

## Claims

1. An organic electroluminescent element comprising:
a transparent substrate,
a sol-gel layer formed on the transparent substrate, the sol-gel layer being made of a sol-gel material and having a microscopic unevenness in its surface,
a high refractive index material layer formed on the sol-gel layer by applying a high refractive index material to fill gaps in the unevenness of the sol-gel layer,
a first electrode formed on a multi-layer compound substrate made of the transparent substrate, the sol-gel layer and the high refractive index material layer,
an organic solid light-emitting layer including an organic light-emitting material formed on the first electrode, and
a second electrode formed on the light-emitting layer,
wherein the microscopic unevenness of the sol-gel layer is formed by nanoimprinting.

2. The organic electroluminescent element according to claim 1,
wherein the first electrode is a transparent electrode made of one selected from ITO, IZO and ZnO, or one selected from Au, Ag and Al, or an alloy including at least one metal selected from the group of Au, Ag and Al.

3. The organic electroluminescent element according to claim 1 or 2,
wherein the transparent substrate is a glass substrate.

4. The organic electroluminescent element according to any of claims 1 to 3,
wherein the refractive index of the sol-gel material is 1.30 to 1.60, and the refractive index of the high refractive index material used for planarizing the unevenness by applying it to gaps in the unevenness of the sol-gel layer is 1.60 to 2.20.

5. The organic electroluminescent element according to any of claims 1 to 4,
wherein the microscopic unevenness of the sol-gel layer is formed by applying a sol-gel material to the transparent substrate, then pressing and heating a die having a microscopic unevenness against the application surface, and separating the die, and wherein the microscopic unevenness is planarized by applying a high refractive index material to the microscopic unevenness.

6. The organic electroluminescent element according to any of claims 1 to 5,
wherein the high refractive index material is an oxide of at least one metal selected from the group consisting of zirconium, aluminum, germanium and titanium.

7. The organic electroluminescent element according to any of claims 1 to 6,
wherein a difference H between valleys and peaks of the microscopic unevenness of the sol-gel layer is 10 nm to 10 µm, and a pitch W between the valleys and peaks of the unevenness is 10 nm to 10 µm.

8. The organic electroluminescent element according to any of claims 1 to 7,
wherein a difference between the refractive index of the transparent substrate and the refractive index of the sol-gel layer is within a range of ±0.2, which is achieved by solidifying the sol-gel material after forming the microscopic unevenness in the sol-gel layer by pressing and heating a die having a microscopic unevenness against the sol-gel material, and separating the die.

9. The organic electroluminescent element according to any of claims 1 to 8,
wherein a difference between the valleys and peaks of the surface planarized by applying the high refractive index material is not greater than 20% of a difference H between valleys and peaks of the unevenness of the sol-gel layer.

10. A method for manufacturing an organic electroluminescent element having a microscopic uneven structure made of a sol-gel material and a high refractive index material on a transparent substrate, the method comprising:
a step of applying a sol-gel material on the transparent substrate;
a step of forming a sol-gel layer having a microscopic unevenness by pressing and heating a die having a microscopic unevenness against the applied sol-gel material, and separating the die,
a step of planarizing the unevenness by applying a high refractive index material on the microscopic unevenness, to form a high refractive index material layer, and
a step of layering a first electrode, an organic solid layer including an organic light-emitting material and a second electrode in that order on the planarized surface.

11. The method for manufacturing an organic electroluminescent element according to claim 10,
wherein the first electrode is a transparent electrode made of one selected from ITO, IZO and ZnO, or one selected from Au, Ag and Al, or an alloy including at least one metal selected from the group of Au, Ag and Al.

12. The method for manufacturing an organic electroluminescent element according to claim 10 or 11,
wherein the transparent substrate is a glass substrate.

13. The method for manufacturing an organic electroluminescent element according to any of claims 10 to 12,
wherein the refractive index of the sol-gel material is 1.30 to 1.60, and the refractive index of the high refractive index material is 1.60 to 2.20.

14. The method for manufacturing an organic electroluminescent element according to any of claims 10 to 13,
wherein the high refractive index material is an oxide of at least one metal selected from the group consisting of zirconium, aluminum, germanium and titanium.

15. The method for manufacturing an organic electroluminescent element according to any of claims 10 to 14,
wherein a difference H between valleys and peaks of the microscopic unevenness of the sol-gel layer is 10 nm to 10 µm, and a pitch W between the valleys and peaks of the unevenness is 10 nm to 10 µm.

16. The method for manufacturing an organic electroluminescent element according to any of claims 10 to 15,
wherein a difference between the refractive index of the transparent substrate and the refractive index of the sol-gel layer is within a range of ±0.2, which is achieved by solidifying the sol-gel material after forming the microscopic unevenness in the sol-gel layer by pressing and heating a die having a microscopic unevenness against the sol-gel material, and separating the die.

17. The method for manufacturing an organic electroluminescent element according to any of claims 10 to 16,
wherein a difference between the valleys and peaks of the surface planarized by applying the high refractive index material is not greater than 20% of a difference H between valleys and peaks of the unevenness of the sol-gel layer.
